Europäisches Patentamt

European Patent Office

Office européen des brevets

(19)

(11) Publication number: **0 140 625**
**B1**

(12) EUROPEAN PATENT SPECIFICATION

(45) Date of publication of patent specification: 08.06.88

(21) Application number: 84306997.2

(22) Date of filing: 10.10.84

(51) Int. Cl.⁴: **C 01 B 19/00,** C 23 C 16/30, C 30 B 25/00, C 30 B 29/46, C 30 B 29/48

(54) Tellurides.

(30) Priority: 19.10.83 GB 8327994

(43) Date of publication of application:
08.05.85 Bulletin 85/19

(45) Publication of the grant of the patent:
08.06.88 Bulletin 88/23

(84) Designated Contracting States:
DE FR IT SE

(56) References cited:
DE-C- 976 126
GB-A- 859 588
GB-A-2 078 695
US-A-2 671 739
US-A-3 451 845
US-A-3 657 006
US-A-3 761 308
US-A-3 808 035
JOURNAL OF THE ELECTROCHEMICAL SOCIETY, vol. 118, no. 4, April 1971, pages 644-647, The Electrochemical Society Inc., Princeton, N.J., USA; H.M. MANASEVIT et al.: "The use of metal-organics in the preparation of semiconductor materials"

(73) Proprietor: THE MARCONI COMPANY LIMITED
The Grove Warren Lane
Stanmore Middlesex HA7 4LY (GB)

(72) Inventor: Hyliands, Michael James
2 Watermeadow Drive
Watermeadow Northampton (GB)
Inventor: Bevan, Malcolm John
23 Neal Close
Northwood Middlesex, HA6 1TQ (GB)
Inventor: Woodhouse, Karen Tace
161 Compton Road
Walverhampton, WV3 9JN (GB)

(74) Representative: Keppler, William Patrick
Central Patent Department Wembley Office The General Electric Company, p.l.c. Hirst Research Centre East Lane
Wembley Middlesex HA9 7PP (GB)

(56) References cited:
CHEMICAL ABSTRACTS, vol. 74, no. 10, March 1971, pages 97-98, no. 43957n, Columbus, Ohio, USA; & SU - A - 278 646 (OBOLONCHIK et al.) 21-08-1970

Courier Press, Leamington Spa, England.

## Description

This invention relates to the synthesis of metal mercury tellurides from hydrogen telluride. The invention relates particularly but not exclusively to the synthesis of mercury tellurides such as $Hg_{1-x}Cd_xTe$, $Hg_{1-x}Mn_xTe$ and $Hg_{1-x}(Mn_{1-y}Cd_y)_xTe$.

Hitherto, such binary and ternary mercury tellurides have commonly been produced by vapour-phase epitaxial methods involving the thermal decomposition of vaporized cadmium and tellurium alkyls in the presence of mercury vapour. However, tellurium alkyls only decompose at high temperatures, so that the formation of cadmium mercury telluride by vapour phse epitaxy has hitherto only been possible at temperatures greater than approximately 350°C. This is frequently disadvantageous.

Furthermore, cadmium and tellurium alkyls form adducts in the vapour phase which decompose at a lower temperature than the decomposition temperature of either of the separate alkyls. Consequently, the value of x in the formula $Cd_xHg_{1-x}Te$ is a complex function of reaction conditions when the cadmium mercury telluride is formed by pyrolysis of mixed cadmium and tellurium alkyls.

According to the invention, a method of producing a metal mercury telluride wherein gaseous flows containing respectively hydrogen telluride, a metal and mercury are uniformly mixed and flowed over a heated substrate to form a layer of metal mercury telluride, is characterised in that the hydrogen telluride is produced by dissociating molecular hydrogen at a tellurium surface. The metal may be cadmium which may be deposited at the substrate out of a volatile organometallic cadmium compound.

The process should be carried out in the absence of light (which photochemically decomposes hydrogen telluride) and the hydrogen telluride should be free from traces of water, oxygen and other sources of free radicals which may initiate an explosive chain reaction. The hydrogen telluride may suitably be diluted in a suitable inert diluent such as hydrogen and should according to reports be at a partial pressure below 23 Torr at room temperature, since explosions can occur at higher partial pressures. Reference is made to the following articles (which relate to the combustion properties of hydrogen telluride) in connection with the safety aspects of the process:

A. S. Yushin, R. V. Pekhomov, Izv. Akad, Nauk. SSSR, Ser. Khim. (12), 2801—3, 1976, (CA 86 100084).

V. S. Mikheev, L. I. Nikolaev, V. Ya. Verkhovskii, A. S. Yuskin, Izv. Akad. Nauk. SSSR. Ser. Khim. (9), 2117—19, 1977 (CA 88: 25066).

G. P. Ustyugov, E. N. Vigdorovich, Izv. Akad. Nauk. SSSR, Neorg. Mater., 5(1), 163—5, 1969 (CA 65: 91010).

We have found that pure hydrogen telluride is unexpectedly kinetically stable even at temperatures as high as 250°C.

U.S. Patent No. 3808035 outlines a method by which a layer is deposited on a substrate at temperatures between 100 and 300°C from one or more gaseous streams of metal-containing material. Various examples are given, including the deposition of tellurides from hydrogen telluride. However this disclosure does not specifically teach the production of metal mercury tellurides, and, in particular, it makes no mention of the special conditions, which we have outlined above, regarding the use of hydrogen telluride.

Cadmium mercury telluride of controlled composition may be made in accordance with the present invention by providing controlled flows of the gaseous hydrogen telluride and at least one of the or each said gaseous sources, allowing said flows to mix and subsequently thermally decomposing substantially all of the flowing mixture over a heated substrate to form a layer of said metal telluride on said substrate. By this msans the composition of the metal telluride can be controlled by controlling the relative flow rates of the components of the gas mixture. The composition of the metal telluride layer may be varied over its thickness by altering the relative flow rates of the components of the gas mixture. The relative flow rates may be altered continuously or discontinuously to give corresponding continuous or discontinuous variations in the composition of the layer over its thickness.

The hydrogen telluride may be generated in situ under controlled conditions.

The gaseous source of mercury is suitably mercury vapour and the value of x in the formula $Cd_xHg_{1-x}Te$ is suitably controlled by controlling the relative flow rates of the gaseous cadmium source (which is suitably dimethyl cadmium) and the hydrogen telluride. The mercury vapour may be in equilibrium with a hot mercury bath. The total partial pressure of the reactants is suitably between 1 and 10 Torr, which may be supplemented by a sufficient partial pressure of hydrogen or other inert diluent to bring the total pressure up to approximately atmospheric pressure.

The substrate may suitably be composed of carbon, in which case it may be locally heated by a microwave or R.F. source. Alternatively, a substrate such as cadmium telluride, indium antimonide, silicon, gallium arsenide, spinel ($MgAl_2O_4$) or sapphire ($Al_2O_3$) may be used, and may be mounted on a carbon susceptor heated by a microwave or R.F. source.

U.K. Patent No. 2078695 describes a method of production of cadmium mercury telluride using a cadmium alkyl and a tellurium alkyl, in which a substrate is mounted on a carbon susceptor and heated by an R.F. coil. However in this case the R.F. heating must be sufficient to crack the alkyls, which means operating at temperaturss of 400—430°C.

Doped cadmium mercury telluride may be grown by a method in accordance with the invention by providing a controlled flow of a thermally decomposable gaseous source of dopant which is decomposed on the hot substrate and codeposited with the other reactants. Thus aluminium, gallium, arsenic and phosphorus dopants may be obtained from vapours of their respective trimethyl compounds and silicon and germanium dopants may be obtained from their respective hydrides. Thus photovoltaic as well as photoconductive cadmium mercury telluride layers may be grown.

Suitable apparatus for generating gaseous hydrogen telluride comprises means for passing a flow of molecular hydrogen over a tellurium surface and means for generating microwave radiation at said surface so as to dissociate the flowing hydrogen. Said surface may be the interior surface of a tellurium tube and the tellurium tube may be surrounded by a microwave cavity. The frequency of the microwave radiation is not critical, but may suitably be 2,450 MHz.

The above apparatus is particularly suitable for making high-purity tellurides (particularly cadmium mercury telluride) because the only reactants are hydrogen and tellurium, which may both be obtained free from hydride-forming impurities.

Methods involving the reaction of mineral acids on metal tellurides (for example aluminium telluride) or the electrolysis of aqueous solutions using a tellurium cathode produce impure hydrogen telluride which cannot easily be purified to a sufficient extent.

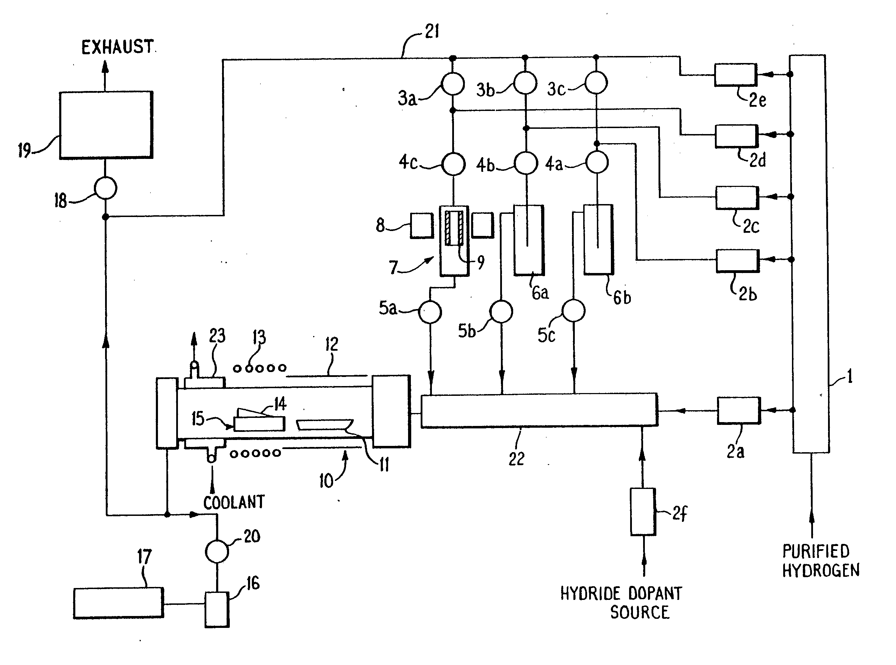

A method in accordance with the invention will now be described by way of example with reference to the accompanying drawing, which shows apparatus for the production of cadmium mercury telluride layers suitable for photodetector applications.

The apparatus shown (which is generally of stainless steel) comprises a manifold 1 from which purified hydrogen is fed to mass-flow meters 2a, 2b, 2c, 2d and 2e. Mass-flow meter 2a directly feeds a tubular reactor 10 with hydrogen and meters 2b, 2c and 2d feed alkyl bubblers 6b, 6a and hydrogen telluride generator 7 via pneumatic valves 4a, 4b and 4c respectively. Mass-flow meter 2e feeds a bypass line 21. Valves 3a, 3b and 3c may be opened and valves 5a, 5b and 5c may be closed to turn off the associated hydrogen telluride generator 7 and alkyl bubblers 6a and 6b. Alkyl bubbler 6a contains dimethyl cadmium at a controlled temperature and alkyl bubbler 6b (which is similarly temperature-controlled) contains an alkyl of any suitable dopant that is required. Additionally or alternatively, dopants such as phosphorus which are conveniently available as hydrides may be added directly to the system via a mass flow controller 2f.

Hydrogen telluride generator 7 comprises a tellurium tube 9 of high purity (typical impurity levels being less than 1 part per million) in a 2450 MHz microwave cavity 8. The intensity of the microwave radiation is controlled so as to control the hydrogen telluride output, the temperature of the tellurium tube 9 remaining at approximately 25°C.

Since the temperatures of the alkyl bubblers 6a and 6b are controlled, controlled flows of cadmium alkyl, hydrogen telluride and optionally hydride and alkyl dopants may be fed, highly diluted with hydrogen, into a mixer 22, and thence to reactor 10. The partial pressure of each reactant vapour is of the order of 1 Torr, the total pressure being approximately 1 atmosphere.

Reactor 10 is provided with a mercury bath 11 which is heated by a furnace 12 to approximately 150°C to provide a mercury atmosphere which mixes thoroughly with the reactant gases from mixer 22. A carbon susceptor 15 is locally heated by an R.F. coil 13 and thermally decomposes the hydrogen telluride, cadmium alkyl and dopant sources (if present) in a smoothly controlled reaction to form an epitaxial layer of cadmium mercury telluride of uniform controlled composition on inclined face 14. A suitable substrate layer such as cadmium telluride may be initially deposited on surface 14 in the absence of a mercury bath. When the layer has reached a suitable thickness, it may be processed by known methods and fabricated into an infra-red photodetector device.

A liquid coolant jacket 23 prevents the reactor from overheating and condenses excess mercury vapour. The excess reactant gases and hydrogen are exhausted by a pump 17 and burnt (for safety reasons) after being passed over an activated charcoal bed 19. A cold trap 26 condenses unreacted reactant gases and the pressure within the system is controlled by valves 18 and 20.

In an alternative embodiment of the invention, hydrogen telluride may be generated *in situ* over a tellurium tube in reactor 10, a suitable microwave cavity being provided around the reactor. Higher temperatures may then be used.

**Claims**

1. A method of producing a metal mercury telluride wherein gaseous flows containing respectively hydrogen telluride, a metal and mercury are uniformly mixed and flowed over a heated substrate (14) to form a layer of said metal mercury telluride, characterised in that said hydrogen telluride is produced by dissociating molecular hydrogen at a tellurium surface (9).

2. A method according to Claim 1 wherein said metal is cadmium.

3. A method according to Claim 2 wherein the cadmium is deposited at said substrate out of a volatile organometallic cadmium compound.

4. A method according to any preceding claim wherein said tellurium surface is located inside a microwave cavity (7) and said molecular hydrogen is dissociated by exposure to microwave radiation the intensity of which is controllable, to control the rate of production of hydrogen telluride.

5. A method according to any preceding claim wherein the temperature of said substrate is below 250°C.

6. A method according to any preceding claim wherein an alkyl of aluminium, gallium, arsenic or phosphorus, or a hydride of silicon or germanium is decomposed with the hydrogen telluride at said substrate (14) to form a doped telluride layer.

7. A method according to any preceding claim wherein the source of gaseous mercury is mercury vapour.

## Patentansprüche

1. Verfahren zum Herstellen eines Metallquecksilbertellurids, in welchem Verfahren gasartige Ströme, die respektive Tellurwasserstoff, ein Metall und Queksilber enthalten, gleichmäßig gemischt werden und man die Ströme ein erhitztes Substrat (14) überströmen läßt, um eine Schicht dieses Metallquecksilbertellurids auszubilden, dadurch gekennzeichnet, daß der Tellurwasserstoff durch Dissoziieren von molekularem Wasserstoff an einer Telluroberfläche (9) erzeugt wird.

2. Verfahren nach Anspruch 1, in welchem das Metall Cadmium ist.

3. Verfahren nach Anspruch 2, in welchem das Cadmium auf dem Substrat aus einer flüchtigen organometallischen Cadmiumverbindung abgeschieden wird.

4. Verfahren nach einem der vorhergehenden Ansprüche, in welchem die Telluroberfläche im Innern eines Mikrowellenhohlraums (7) liegt und der molekulare Wasserstoff durch Aussetzen einer Mikrowellenstrahlung, deren Intensität steuerbar ist, um die Produktionsrate von Tellurwasserstoff zu steuern, dissoziiert wird.

5. Verfahren nach einem der vorhergehenden Ansprüche, in welchem die Temperatur des Substrats unter 250°C liegt.

6. Verfahren nach einem der vorhergehenden Ansprüche, in welchem ein Alkyl von Aluminium, Gallium, Arsen oder Phosphor oder ein Hydrid von Silicium oder Germanium mit dem Tellurwasserstoff am Substrat (14) zersetzt werden, um eine dotierte Telluridschicht auszubilden.

7. Verfahren nach einem der vorhergehenden Ansprüche, in welchem die Quelle gasartigen Quecksilbers Quecksilberdampf ist.

## Revendications

1. Procédé pour produire un tellurure de mercure et de métal, selon lequel on mélange uniformément des courants gazeux contenant respectivement du tellurure d'hydrogène, un métal et du mercure, et on les fait circuler sur un substrat (14) chauffé pour former une couche dudit tellurure de mercure et de métal, procédé caractérisé en ce que ledit tellurure d'hydrogène est produit par dissociation d'hydrogène moléculaire sur une surface (9) de tellure.

2. Procédé selon la revendication 1, dans lequel ledit métal est le cadmium.

3. Procédé selon la revendication 2, dans lequel le cadmium est déposé sur ledit substrat à partir d'un composé organo-métallique de cadmium volatil.

4. Procédé selon l'une quelconque des revendications précédentes, dans lequel ladite surface de tellure est située à l'intérieur d'une cavité (7) génératrice de microondes, et ledit hydrogène moléculaire est dissocié par exposition au rayonnement des micro-ondes dont l'intensité est réglable, afin de régler le débit de production de tellurure d'hydrogène.

5. Procédé selon l'une quelconque des revendications précédentes, dans lequel la température dudit substrat est inférieure à 250°C.

6. Procédé selon l'une quelconque des revendications précédentes, dans lequel un alkyl-aluminium, -gallium, -arsenic ou -phosphore, ou un hydrure de silicium ou de germanium, est décomposé avec le tellurure d'hydrogène sur ledit substrat (14) pour former une couche de tellurure dopé.

7. Procédé selon l'une quelconque des revendications précédentes, dans lequel la source de mercure gazeux est de la vapeur de mercure.

EXHAUST

PURIFIED
HYDROGEN

HYDRIDE DOPANT
SOURCE

COOLANT

0 140 625